# EUROPÄISCHE PATENTSCHRIFT

(11) **EP 2 096 775 B1**
(45) Veröffentlichungstag und Bekanntmachung des Hinweises auf die Patenterteilung: **14.01.2015**
(21) Anmeldenummer: 09000468.0
(22) Anmeldetag: 15.01.2009
(51) Int. Cl.: H01R 12/71, G01R 1/04

(54) **Vorrichtung zur Kontaktierung eines T/R-Moduls mit einer Testeinrichtung**
Device for contacting a T/R module with a test device
Dispositif de mise en contact d'un module T/R à l'aide d'un dispositif de test

(30) Priorität: 26.02.2008 DE 102008011240
(43) Veröffentlichungstag der Anmeldung: 02.09.2009
(73) Patentinhaber: Airbus Defence and Space GmbH, 85521 Ottobrunn (DE)
(72) Erfinder: Schmegner, Karl-Ernst, Dr., 89278 Nersingen (DE); Müller, Thomas Johannes, 89155 Erbach (DE); Höfer, Georg, 89173 Lonsee (DE); Rittmeyer, Rainer, 89081 Ulm (DE)
(74) Vertreter: Meel, Thomas

(56) Entgegenhaltungen:
- EP-A1- 0 388 485
- US-A- 4 947 111
- US-A- 4 980 636

## Beschreibung

Die Erfindung betrifft eine Vorrichtung zur Kontaktierung eines T/R-Moduls mit einer Testeinrichtung. T/R-Modul steht dabei für Transmit/Receive-Modulen, wie sie insbesondere in aktiven Antennen im HF-Bereich zum Einsatz kommen.

Die Kontaktierung und damit die Charakterisierung von T/R-Modulen (Prüfling) kann nach dem Stand der Technik durch den Einbau in spezielle Messhalterungen erfolgen. In diesen wird die HF-Verbindung zur Tester-Umgebung durch koaxiale Stecker und zum Prüfling durch Adaptoren mit gebondeten Drähten und/oder Bändchen hergestellt. In ähnlicher Weise erfolgt die Versorgung mit DC und die Verbindung zu den Steuersignalen. Nach erfolgtem Test werden die gebondeten Verbindungen wieder entfernt. Auf den Anschlusspads der Prüflinge bleiben Reste der Verbindung und sichtbare Spuren zurück.

Dieses mechanisch aufwändige und zudem nicht spurenlose (bzw. rückstandsfreie) Kontaktieren von Prüflingen kann stattdessen mit Hilfe von Nadeladaptern für die niederfrequente Ansteuerung bzw. DC-Versorgung durchgeführt werden. Die hochfrequenten Signale werden hierfür mit speziellen koaxialen Prüfspitzen (HF-Probes) zugeführt. Dabei muss auch bei dieser Art der Kontaktierung beachtet werden, dass sowohl die Nadeln als auch die Prüfspitzen beim Kontaktieren auf den Anschlusspads Spuren (Kratzer) hinterlassen, die die weitere Verarbeitung der Module (Einbau in ein System per Bondverbindung) beeinträchtigen können. Zudem sind die Anschlusspads aus Platzgründen und aufgrund von HF-technischen Anforderungen sehr klein gehalten. Um für die Messung eine sichere Kontaktierung der Module zu gewährleisten, müssen deshalb sowohl der Prüfling als auch die Prüfspitzen unabhängig voneinander unter Zuhilfenahme eines Mikroskops manuell optisch zueinander ausgerichtet werden. Nur aufgrund dieser recht aufwändigen Vorgehensweise wird sichergestellt, dass die individuellen mechanischen Toleranzen der Prüflinge sich nicht störend auf die elektrischen Eigenschaften der Module auswirken. Ferner ist anzumerken, dass sich die Qualität der Kontaktierung direkt auf die Güte der Messergebnisse auswirkt und qualitativ hochwertige Kontaktierungen nur von erfahrenem Bedienpersonal erreicht werden.

Bei dieser Art der Kontaktierung müssen die einzelnen Prüfspitzen individuell ausgerichtet werden, typischerweise unter Anwendung optischer Methoden unter einem Mikroskop, was sehr zeitaufwändig ist. Darüber hinaus ist die Güte der Kontaktierung stark abhängig von den Fähigkeiten des Bedienpersonals.

US 4,947,111 beschreibt eine Vorrichtung zum Testen von Mikrowellen-IC-Bausteinen im GHz-Frequenzbereich, durch die Verwendung, unter anderem, eines HF-Moduls. Die Positionierung der Pins des HF-Moduls wird durch eine spezielle Führung gelöst.

EP 0 388 485 beschreibt eine Messfassung, insbesondere für Mikrowellen-Bauelemente, die eine Schiebe-Einrichtung zur Einführung des zu messenden Bauelements in die Messfassung und zur Positionierung und Kontaktierung des zu messenden Bauelements in der Messfassung verwendet.

US 4,980,636 beschreibt eine Kontaktiereinheit zum Testen von Mikrowellen-Bauelementen mit Microstrip-Leitungen.

Aufgabe der vorliegenden Erfindung ist es deshalb, eine Vorrichtung zur Kontaktierung von T/R-Modulen zu schaffen, mit der die Nachteile der vorstehend geschilderten Kontaktiermethoden überwunden werden, insbesondere sollte eine leicht zu handhabende, reproduzierbare Kontaktierung hoher Güte geschaffen werden.

Diese Aufgabe wird mit der Vorrichtung gemäß Patentanspruch 1 gelöst. Vorteilhafte Ausführungen sind Gegenstand von Unteransprüchen.

Gemäß der Erfindung wird die optische Ausrichtung des Prüflings durch eine mechanische Führung und Zentrierung einer rahmenförmigen Kontaktiereinheit am Rahmen des zu prüfenden T/R Moduls ersetzt, so dass die Kontaktierung sämtlicher Anschlüsse in einem Arbeitsgang erfolgen kann. Ein an der Kontaktiereinheit angeordnetes Leitungssubstrat stellt die Verbindung zu den Anschlusstoren der Testeinrichtung her. Es ist als geschirmte Triplate-Leitung ausgebildet. Die Kontaktiereinheit weist Kontaktelemente (z.B. Federkontaktstifte) auf und verbindet damit das Leitungssubstrat mit den entsprechenden Kontaktpads des T/R-Moduls.

Zur Erreichung einer sicheren und zuverlässigen Verbindung zu den T/R-Modulen entfällt bei der erfindungsgemäßen Art der Kontaktierung das individuelle Ausrichten der Prüfspitzen zum Prüfling. Das hierzu erforderliche Betrachten durch ein Mikroskop entfällt ebenfalls.

Alle erforderlichen Kontakte, d.h. neben den hochfrequenten Signalen auch die niederfrequenten Signale oder DC-Signale, können in einem Arbeitsgang sicher und gleichzeitig geschlossen werden.

Mit der erfindungsgemäßen Vorrichtung ist die Güte der Kontaktierung weitestgehend unabhängig von den Fähigkeiten des Bedienpersonals. Es wird somit sichergestellt, dass die Eigenschaften der Prüflinge unverfälscht wiedergegeben werden.

Ein weiterer Vorteil ist die sehr einfach durchzuführende Kalibrierung des Messplatzes, bei der dasselbe Kontaktierprinzip angewandt werden kann. Die hierfür angefertigten Kalibrierelemente besitzen denselben Aufbau wie das Leitungssubstrat und weisen unterschiedlich lange Koplanar-Leitungen, die auf einem Metallträger montiert sind, auf. Der Metallträger besitzt eine an den Prüfling angenäherte Außenkontur und ist genauso einfach in die Testhalterung einzulegen und zu kontaktieren wie die T/R-Module. Hierfür ist kein zusätzlicher Aufwand zum Einstellen und Ausrichten erforderlich. Selbst die Reihenfolge des Einlegens kann vom Steuerprogramm dem Bediener vorgegeben werden.

Die Erfindung wird anhand von Ausführungsbeispielen unter Bezugnahme auf Figuren näher erläutert. Es zeigen:
- Fig. 1: eine erfindungsgemäße Vorrichtung zur Kontaktierung mit mechanischer Führung in Seitenansicht;
- Fig. 2: ein Leitungssubstrat in Querschnittsdarstellung;
- Fig. 3: den Anschluss eines Koaxialsteckers am Ende des Leitungssubstrats;
- Fig. 4: ein Leitungssubstrat in Untersicht;
- Fig. 5: eine erfindungsgemäße Vorrichtung mit kontaktiertem T/R-Modul in Querschnittsdarstellung;
- Fig. 6: Kontaktierelemente am Übergang vom T/R-Modul zur Kontaktiereinheit;
- Fig. 7: Kontaktierelemente am Übergang von der Kontaktiereinheit zum Leitungssubstrat.

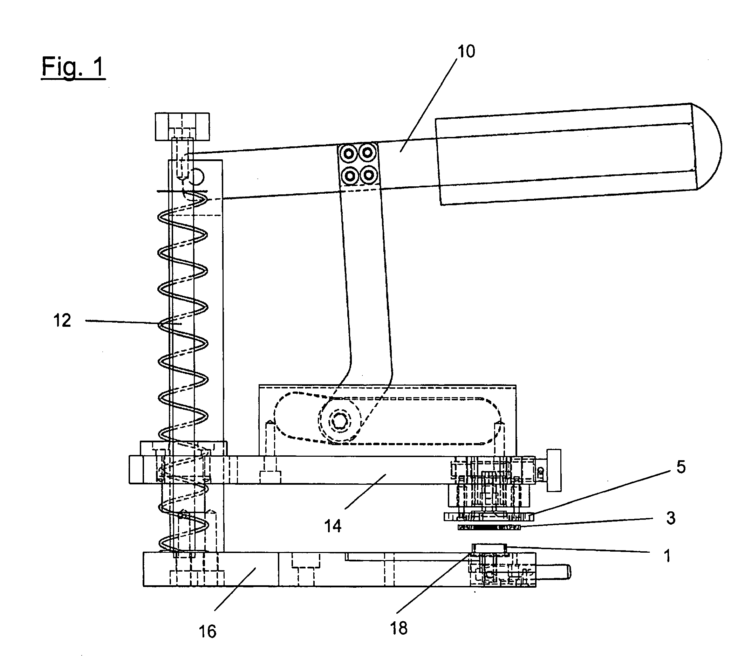

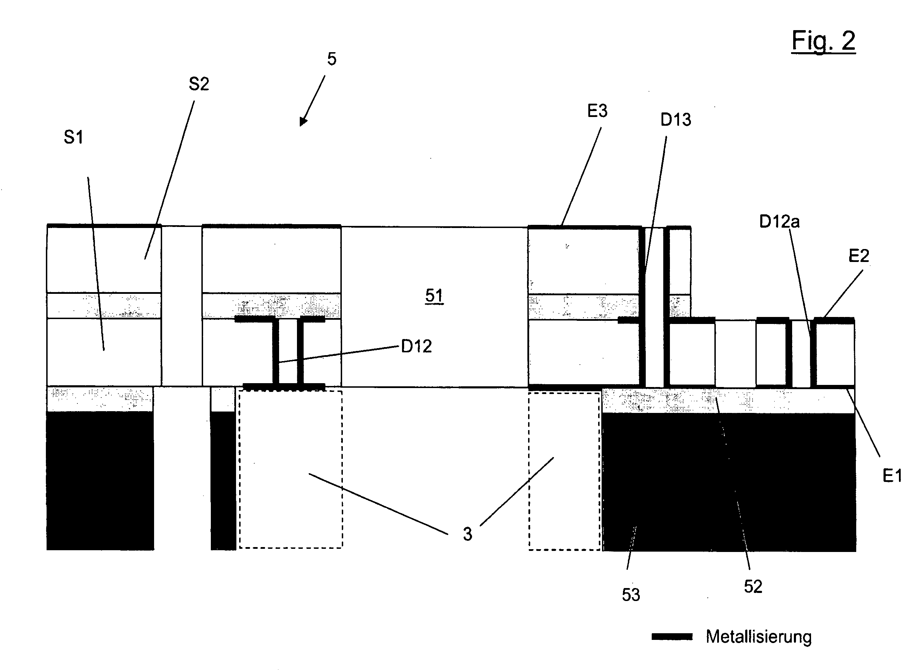

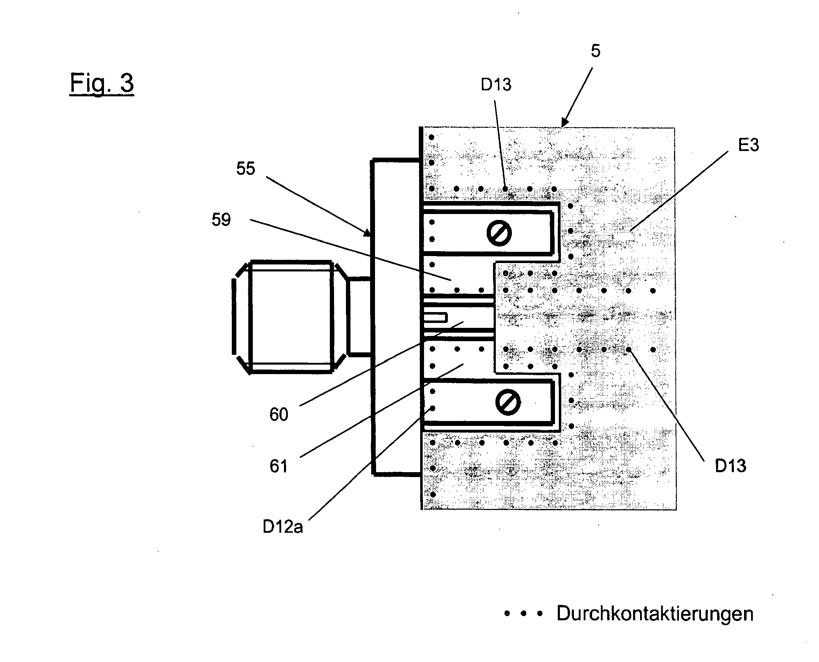

Fig. 1 zeigt die Gesamtdarstellung einer erfindungsgemäßen Vorrichtung. Das T/R-Modul 1 wird zur mechanischen Vorjustierung in einer Wanne 18 in der Basisplatte 16 der Vorrichtung eingelegt. Das Leitungssubstrat 5 mit der an seiner Unterseite angeordneten Kontaktiereinheit 3 ist an einer beweglichen Platte 14 angeordnet. Leitungssubstrat 5 und Kontaktiereinheit 3 sind elektrisch über mehrere Kontakte miteinander verbunden, was weiter unten noch im Detail ausgeführt werden wird. In der Fig. 1 ist zur besseren Übersichtlichkeit die Kontaktiereinheit 3 getrennt vom Leitungssubstrat 5 dargestellt. In Wirklichkeit liegt die Kontaktiereinheit 3 vertikal nach oben verschoben in einer Einbuchtung des Leitungssubstrats 5 (und bündig zu dessen Unterseite) angeordnet, so dass sie in dieser Seitenansicht nicht zu erkennen wäre. Sowohl Leitungssubstrat 5 als auch Kontaktiereinheit 3 sind von der Form eines rechtwinkligen, innen offenen Rahmens ausgebildet, was in den Fig. 2 und 3 deutlich wird.

Die bewegliche Platte 14 und die daran angeordneten Leitungssubstrat 5 und Kontaktiereinheit 3 können durch eine Aufwärts- oder Abwärtsbewegung des Hebels 10 parallel in ihrer vertikalen Position verschoben werden, wobei bei der Abwärtsbewegung Arbeit gegen die Druckfeder 12 geleistet werden muss.

Zur Kontaktierung des in der Wanne 18 grob vorpositionierten T/R-Moduls 1 wird der Hebel 10 nach unten bewegt. Die rahmenförmige Kontaktiereinheit 3 umschließt in seiner Abwärtsbewegung den äußeren Rahmen des T/R-Moduls 1 und wird dadurch zentriert und relativ zum T/R-Modul 1 eindeutig positioniert (die mechanische Hebelvorrichtung weist das dazu notwendige Spiel auf). Dadurch werden gleichzeitig die Kontaktelemente (hier: Federkontaktstifte) der Kontaktiereinheit 3 mit den komplementären Kontaktelementen (hier: Kontaktflächen) am T/R-Modul 1 verbunden, so dass der Kontakt zum T/R-Modul 1 hergestellt ist.

Fig. 2 zeigt das Leitungssubstrat 5 in Querschnittsdarstellung. Es ist als sogenannte geschirmte Triplate-Leitung ausgebildet. Diese umfasst durch zwei Substrate S1, S2 getrennt drei parallele Metallisierungsebenen E1,E2,E3, wobei die mittlere Metallisierungsebene sich unterteilt in drei getrennte (koplanare) Einzelleiter mit einem zentralen Innenleiter.

Da das Leitungssubstrat 2 die Form eines rechteckigen Rahmens aufweist, umschließt er einen offenen inneren Bereich 51 (dies kann z.B. durch Ausfräsen eines geschlossenen Substrats erreicht werden). Das Leitungssubstrat 5 ist mittels einer Klebeschicht 52 auf eine Trägerplatte 53 aus Aluminium aufgeklebt. Die Lage des ebenfalls rahmenförmigen Kontaktierelements 3 ist durch gestrichelte Linien angedeutet.

Innerhalb des Leitungssubstrats 5 befinden sich metallisierte Durchkontaktierungen D12, D12a, D13 sowohl von der unteren, modulseitigen E1 zur modulfernen E3 Metallisierungsebene wie auch von der unteren, modulseitigen E1 zur mittleren E2 Metallisierungsebene. Diese dienen entweder zur Leitung des HF-Signals oder zur Unterdrückung jedweder Art von Überkopplungen durch höhere Moden.
Ebenfalls in der Fig. 2 enthaltene Bohrungen ohne Metallisierung dienen zur mechanischen Befestigung der Teile untereinander.

Das Leitungssubstrat 5 weist an einem Ende einen Übergang von der geschirmten Triplate-Leitung zu einer geschirmten Koplanarleitung auf. Dazu wurde die obere, modulferne Metallisierungsebene E3 sowie das obere Substrat S2 bis zur mittleren Metallisierungsebene E2 entfernt. In diesem Bereich kann der Stecker zum Anschluss einer Koaxialleitung der Testeinrichtung angebracht werden.

Um im Übergangsbereich die Anregung von höheren Moden, welche sich entlang des Steckerflansches und dann weiter zwischen Leitungssubstrat 5 und metallischer Trägerplatte 53 ausbreiten können, zu unterdrücken, wird als Klebeschicht 52 vorteilhaft eine leitfähige Klebefolie verwendet.

Fig. 3 zeigt diesen Übergangsbereich des Leitungssubstrats 5 in Draufsicht, wobei der koaxiale Stecker 55 bereits angeschlossen ist. Die obere, modulferne Metallisierungsebene E3 sowie das darunterliegende Substrat S2 wurden entfernt, soweit es zur Montage des Steckers 55 notwendig ist. Dadurch sind die drei koplanaren Einzelleiter (Innenleiter 60, Außenleiter 59, 61) der mittleren Metallisierungsebene E2 in diesem Bereich freigelegt. Der Innenleiter 60 wird mit dem Innenleiter des Koaxialsteckers 55 verbunden.

Zur Unterdrückung höherer Moden sind entlang der Außenkontur des koaxialen Steckers Durchkontaktierungen D13 zwischen den beiden äußeren Metallisierungsebenen E1 ,E3 der Triplate-Leitung vorgesehen. Für denselben Zweck sind entlang des Steckerflansches weitere Durchkontaktierungen D12a zwischen der unteren, modulnahen Metallisierungsebene E1 und der mittleren Metallisierungsebene E2 vorhanden.

Zur Abschirmung des HF-Signals sind weitere Durchkontaktierungen D13 zwischen modulseitiger E1 und modulferner E3 Metallisierungsebene beidseitig entlang des Innenleiters 60 der mittleren Metallisierungsebene E2 vorhanden. Im Übergangsbereich, in dem die obere Metallisierungsebene E3 nicht vorhanden ist, verbinden diese Innenleiter-parallelen Durchkontaktierungen untere, modulnahe E1 und mittlere E2 Metallisierungsebene.

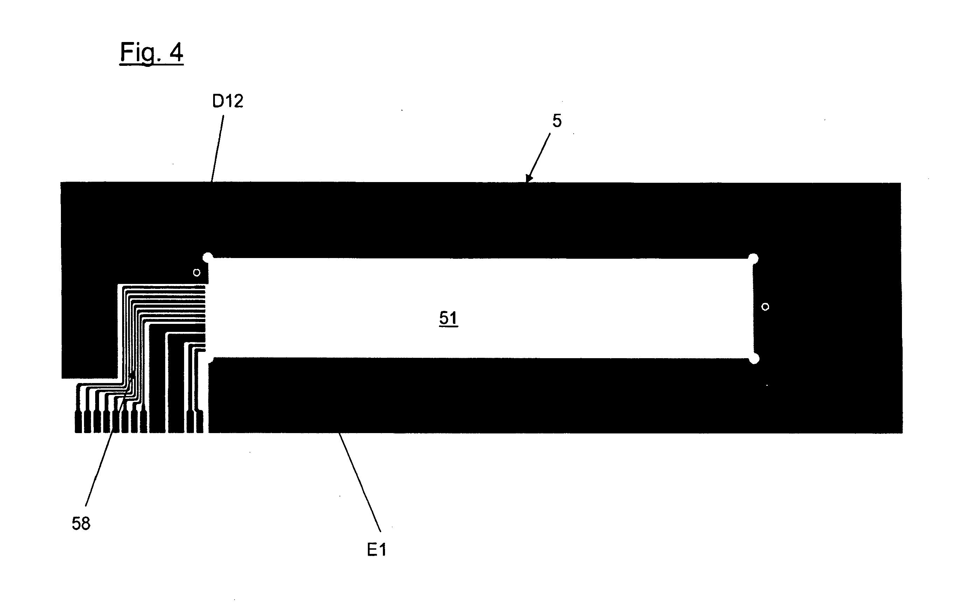

Fig. 4 zeigt das Leitungssubstrat 5 von unten, d.h. gesehen vom T/R-Modul. Man erkennt die modulseitige Metallisierungsebene E1 in ihrer rechtwinkligen, rahmenförmigen Ausbildung mit innerer Öffnung 51.

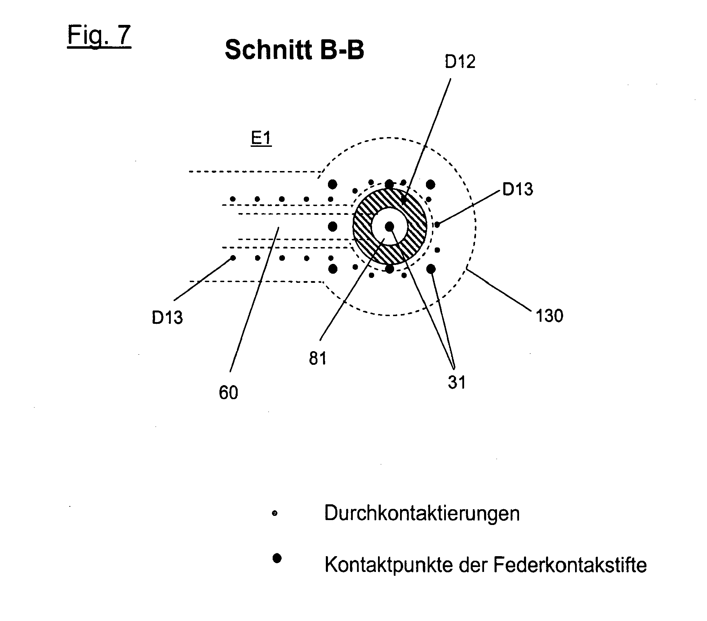

Die Durchkontaktierung D12 dient zur Führung des HF-Signals vom T/R-Modul auf die mittlere Metallisierungsebene E2 der Triplate-Leitung. Sie wird weiter unten im Zusammenhang mit Fig. 7 noch näher erläutert werden.

Die in der Metallisierungsebene E1 eingearbeiteten Leitungsstrukturen 58 für die DC (Stromversorgung) und Steuersignale sind ebenfalls zu erkennen. Diese Leitungsstrukturen umfassen Kontaktflächen zur Kontaktierung mit den verwendeten Federkontaktstiften der Kontaktiereinheit. Die DC- und die Steuersignale können auf dieser Ebene direkt zu einer an dem Leitungssubstrat 5 angeordneten Leiterkarte (nicht eingezeichnet) geführt und von dort per mehrpoligem Stecker zu den Messgeräten der Testeinrichtung weitergeleitet werden.

Die Integration der auf der separaten Leiterkarte angebrachten Stromversorgung in das Leitungssubstrat bieten einige Vorteile. So können kurze Leitungsverbindungen realisiert werden, die für einen störungsfreien Betrieb der T/R-Module erforderlich sind. Gleiches gilt für die HF-Verbindungen. Zur Unterdrückung bzw. Vermeidung von Verkopplungen und/oder Resonanzeffekten werden im Aufbau des Leitungssubstrats und auch in den weiteren Verbindungsstrukturen vorteilhaft kurze Verbindungswege realisiert.

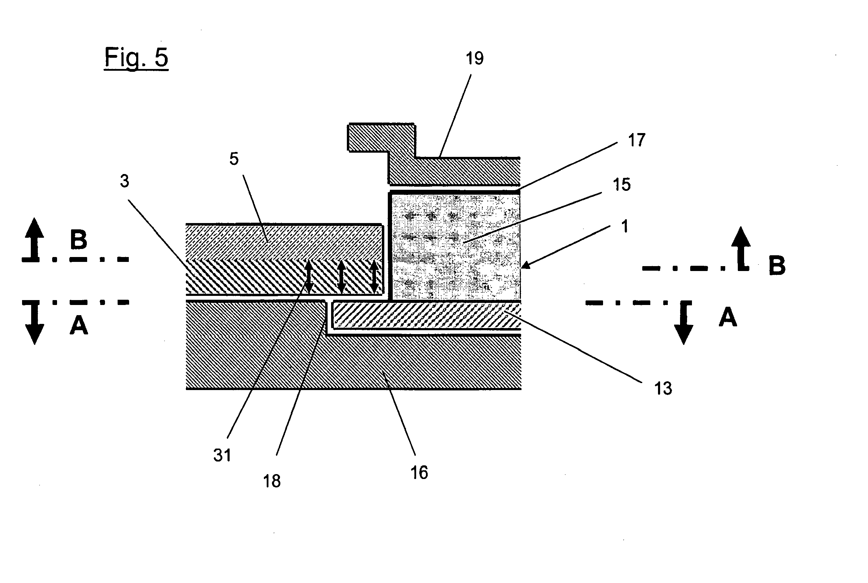

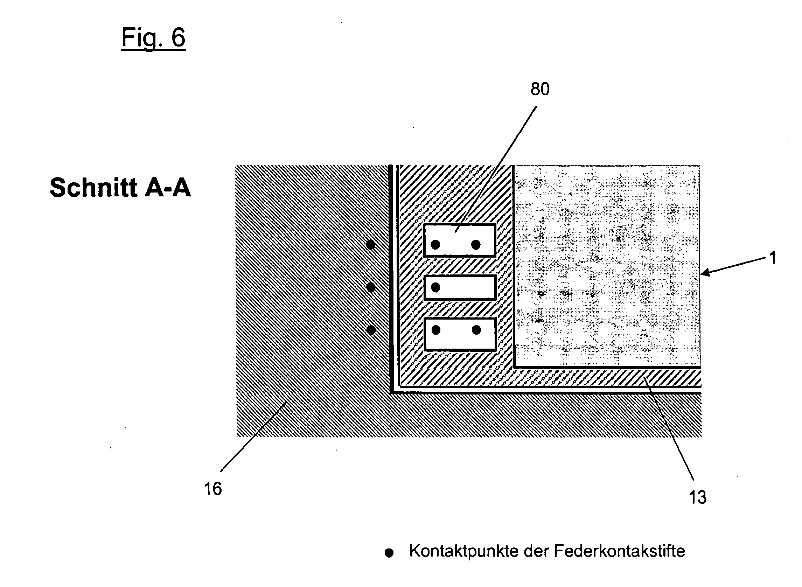

Fig. 5 zeigt eine erfindungsgemäße Vorrichtung mit kontaktiertem T/R-Modul 1 in Querschnittsdarstellung. Das kontaktierte T/R-Modul 1 umfasst eine Bodenplatte 13, an dessen Oberseite Kontaktflächen (siehe Fig. 6) angeordnet sind, sowie ein Modulgehäuse mit Rahmen 15 und Deckel 17. Das Modul 1 liegt in einer Wanne 18 aus elektrisch leitfähigem Material innerhalb der Basisplatte 16 der Vorrichtung. Das Leitungssubstrat 5 und die daran angeordnete Kontaktiereinheit 3 umschießen den Rahmen 15 des Moduls 1 von allen vier Umfangsseiten (in Fig. 5 so nicht zu erkennen, da sie lediglich eine Seite der Anordnung zeigt). Innerhalb der Kontaktiereinheit 3 erkennt man elektrische Kontaktelemente 31, die hier als Federkontaktstifte ausgebildet sind, welche den elektrischen Kontakt zwischen dem T/R-Modul 1 und dem Leitungssubstrat 5 vermitteln.

Mit der erfindungsgemäßen Vorrichtung können nicht nur verschlossene Module gemessen, sondern auch noch offene Module einem Vortest unterzogen werden. Zur Sicherstellung einer elektrisch wirksamen Abdeckung der offenen Module kann in den sich von oben herabsenkenden Teil der Vorrichtung eine Andruckplatte 19 vorgesehen werden. Diese presst den hierbei lose aufliegenden Deckel 17 auf den Rahmen 15 des Moduls 1. Zur Unterdrückung von Oberflächenwellen, die sich von der Ausgangsseite des Moduls 1 zwischen Kontaktiereinheit 3 und Modulrahmen 15 und weiter auf der Oberfläche des Moduldeckels 17, sowie zwischen Kontaktiereinheit 3 und Modulrahmen 15 auf den Eingang des Moduls 1 ausbreiten, wird die Form der Andruckplatte 19 an mindestens einem ihrer Ränder stufenförmig ausgebildet wie in Fig. 5 dargestellt. Diese Form der Andruckplatte 19 bewirkt eine ausreichend hohe Störung (Unterbrechung) des beschriebenen Ausbreitungsweges.

Fig. 6 zeigt eine Ansicht entlang der Linie A-A in Fig. 5. Man erkennt die metallischen, koplanaren Kontaktflächen 80 am Ein-/Ausgang des T/R-Moduls 1. Die Kontaktpunkte der Federkontaktstifte innerhalb der Kontaktiereinheit sind ebenfalls markiert. Der Ground/Signal/Ground-Übergang wird mit den drei Federkontaktstiften der mittleren Reihe hergestellt. Zur Unterdrückung von Wellen, die sich in der Kontaktiereinheit (diese wirkt als dielektrischer Wellenleiter) ausbreiten, werden innerhalb der Kontaktiereinheit zusätzliche Federkontaktstifte zur Schirmung des HF Signals eingebracht (in Fig. 5 die linke und rechte Reihe der Kontaktstifte), welche die das HF-Signal führende Kontaktstifte der mittleren Reihe umgeben. Sie bewirken in der Kontaktiereinheit 3 eine an eine Koaxialleitung angelehnte Führung des HF-Signals. Durch diese Maßnahme wird die Performance des Ground/Signal/Ground-Übergangs von Koplanar-Leitung (T/R-Modul) auf Triplate-Leitung (Leitungssubstrat) wesentlich verbessert (Entkopplung).

Fig. 7 zeigt die Anschlussgeometrie für das HF-Signal an der Unterseite des Leitungssubstrats, also an der modulseitigen Metallisierungsebene E1 der Triplate-Leitung (Ansicht entlang der Linie B-B in Fig. 5). Ebenfalls eingezeichnet sind die Kontaktpunkte 31 der Federkontaktstifte der Kontaktiereinheit 3.

Das HF-Signal wird mittels der Durchkontaktierung D12 (siehe auch Fig. 2) auf die mittlere Metallisierungsebene E2 der geschirmten Triplate-Leitung gebracht. Diese Durchkontaktierung befindet sich in der Ansicht der Fig. 7 hinter der leitfähigen Kontaktfläche 81, auf der sich der Kontaktpunkt 31 eines Federkontaktstiftes befindet. Der diese Kontaktfläche umgebende ringförmige nichtmetallisierte Bereich der Metallisierungsebene E1 ist schraffiert dargestellt.

Die Durchkontaktierung D12 für die Führung des HF-Signals ist innerhalb des Leitungssubstrats 5 vorteilhaft von weiteren Durchkontaktierungen D13 zur elektrischen Verbindung von modulseitiger und modulferner Metallisierungsebene umgeben. Derartige Durchkontaktierungen D13 sind auch beidseitig entlang des Innenleiters 60 (in der Fig. 7 gestrichelt dargestellt) der mittleren Metallisierungsebene E2 vorhanden. In der mittleren Metallisierungsebene sind die Durchkontaktierungen D13 über eine Metallisierungsfläche 130 (gestrichelt eingezeichnet) miteinander verbunden. Entsprechend der Lage der Durchkontaktierungen D13 umgibt die Metallisierungsfläche 130 die Durchkontaktierung in einem kreisförmigen Abschnitt, der sich in zwei geradlinigen Abschnitten beidseitig und parallel zum Innenleiter 60 fortsetzt.

Diese zusätzlichen Maßnahmen sind zur Schirmung und zur Unterdrückung von höheren Moden und unerwünschten Ausbreitung von Feldern vorgesehen.

## Patentansprüche

1. Vorrichtung zur Kontaktierung eines T/R-Moduls (1) mit einer Testeinrichtung zur Übertragung von HF-Signalen, mit folgenden Elementen:
- eine mechanisch geführte, rahmenförmige Kontaktiereinheit (3), welche eine Mehrzahl von Kontaktelementen (31) zur Kontaktierung des TR-Moduls (1) aufweist, wobei zur Kontaktierung die Kontaktiereinheit (3) das T/R-Modul (1) umschließt, wodurch die Kontaktiereinheit (3) relativ zum T/R-Modul (1) derart positioniert wird, dass der Kontakt zum T/R-Modul (1) über die Kontaktelemente (31) in einem Arbeitsgang hergestellt wird,
- ein an der Kontaktiereinheit (3) angeordnetes und mit ihr elektrisch verbundenes Leitungssubstrat (5), welches als geschirmte Triplate-Leitung ausgebildet ist, über welches die HF-Signale zur Testeinrichtung weitergeführt werden können.

2. Vorrichtung nach Anspruch 1, **dadurch gekennzeichnet, dass** eine Wanne (18) vorhanden ist, in welche das zu testende T/R-Modul (1) zur Grobpositionierung eingelegt wird.

3. Vorrichtung nach Anspruch 1 oder 2, **dadurch gekennzeichnet, dass** die Kontaktelemente (31) der Kontaktiereinheit (3) als Federkontaktstifte ausgebildet sind, die bei der Kontaktierung metallische Kontaktflächen (80,81) an Leitungssubstrat (5) und T/R-Modul (1) berühren.

4. Vorrichtung nach Anspruch 3, **dadurch gekennzeichnet, dass** die den Kontakt vermittelnden Kontaktelemente (31) der Kontaktiereinheit (3) von weiteren Kontaktelementen zur Schirmung des HF-Signals umgeben sind.

5. Vorrichtung nach einem der vorangehenden Ansprüche, **dadurch gekennzeichnet, dass** das HF-Signal über eine Durchkontaktierung (D12) von der modulseitigen (E1) zur mittleren (E2) Metallisierungsebene der Triplate-Leitung geführt wird.

6. Vorrichtung nach Anspruch 5, **dadurch gekennzeichnet, dass** die Durchkontaktierung für das HF-Signal (D12) von Durchkontaktierungen (D13) zwischen der modulseitigen (E1) und der modulfernen (E3) Metallisierungsebene der Triplate-Leitung umgeben ist.

7. Vorrichtung nach einem der vorangehenden Ansprüche, **dadurch gekennzeichnet, dass** beidseitig entlang des Innenleiters (60) der mittleren Metallisierungsebene (E2) weitere Durchkontaktierungen (D13) zwischen modulseitiger (E1) und modulferner (E3) Metallisierungsebene vorhanden sind.

8. Vorrichtung nach Anspruch 6 oder 7, **dadurch gekennzeichnet, dass** die Durchkontaktierungen (D13) zwischen der modulseitigen (E1) und der modulfernen (E3) Metallisierungsebene in der mittleren Metallisierungsebene (E2) mittels einer Metallisierungsfläche (130) miteinander verbunden sind.

9. Vorrichtung nach einem der vorangehenden Ansprüche 2 bis 8, **dadurch gekennzeichnet, dass** am Ende der Triplate-Leitung ein Übergang auf eine geschirmte Koplanarleitung vorhanden ist.

10. Vorrichtung nach Anspruch 9, **dadurch gekennzeichnet, dass** die Koplanarleitung zum Anschluss der Testeinrichtung mit einem koaxialen Stecker (55) verbunden ist.

11. Vorrichtung nach Anspruch 10, **dadurch gekennzeichnet, dass** auf der Triplateleitung entlang der Außenkontur des koaxialen Steckers (55) Durchkontaktierungen (D13) zwischen der modulseitigen (E1) und der modulfernen (E3) Metallisierungsebene der Triplate-Leitung vorhanden sind.

12. Vorrichtung nach einem der vorangehenden Ansprüche, **dadurch gekennzeichnet, dass** über das Leitungssubstrat (5) und weitere, innerhalb der Kontaktiereinheit (3) vorhandener Kontaktstifte Gleichstrom- und Steuersignale zwischen einer am Leitungssubstrat (5) angeordneten Leiterkarte und dem T/R-Modul (1) übertragen werden können, wobei die Signalführung innerhalb der modulseitigen Metallisierungsebene (E1) der Triplate-Leitung erfolgt.

13. Vorrichtung nach einem der vorangehenden Ansprüche, **dadurch gekennzeichnet, dass** sie eine Andruckplatte (19) umfasst, die auf das Gehäuse des T/R-Moduls (1) drückt, wobei die Andruckplatte (19) an mindestens einer ihrer Ränder stufenförmig ausgebildet ist.

## Claims

1. Apparatus for making contact between a T/R module (1) and a test device for transmission of RF signals, having the following elements:
- a mechanically guided contact-making unit (3) which is in the form of a frame and has a plurality of contact elements (31) for making contact with the T/R module (1), wherein the contact-making unit (3) encloses the T/R module (1) for contact-making purposes, as a result of which the contact-making unit (3) is positioned relative to the T/R module (1) in such a way that the contact with the T/R module (1) is established via the contact elements (31) in one work operation,
- a line substrate (5) which is arranged on the contact-making unit (3), is electrically connected to it and is in the form of a shielded triplate line, via which the RF signals can be passed to the test device.

2. Apparatus according to Claim 1, **characterized in that** a trough (18) is present, into which the T/R module (1) to be tested is inserted for coarse positioning.

3. Apparatus according to Claim 1 or 2, **characterized in that** the contact elements (31) of the contact-making unit (3) are in the form of spring contact pins which
touch metallic contact surfaces (80, 81) on the line substrate (5) and T/R module (1) when contact is made.

4. Apparatus according to Claim 3, **characterized in that** the contact-imparting contact elements (31) of the contact-making unit (3) are surrounded by further contact elements for shielding the RF signal.

5. Apparatus according to one of the preceding claims, **characterized in that** the RF signal is passed via a plated-through contact (D12) from the metallization plane on the module side (E1) to the middle metallization plane (E2) of the triplate line.

6. Apparatus according to Claim 5, **characterized in that** the plated-through contact for the RF signal (D12) is surrounded by plated-through contacts (D13) between the metallization plane on the module side (E1) and the metallization plane remote from the module (E3) of the triplate line.

7. Apparatus according to one of the preceding claims, **characterized in that** further plated-through contacts (D13) are provided between the metallization plane on the module side (E1) and the metallization plane remote from the module (E3), on both sides along the inner conductor (60) of the middle metallization plane (E2).

8. Apparatus according to Claim 6 or 7, **characterized in that** the plated-through contacts (D13) between the metallization plane on the module side (E1) and the metallization plane remote from the module (E3) are connected to one another in the middle metallization plane (E2) by means of a metallization surface (130).

9. Apparatus according to one of the preceding Claims 2 to 8, **characterized in that** a junction to a shielded coplanar line is provided at the end of the triplate line.

10. Apparatus according to Claim 9, **characterized in that** the coplanar line for connection of the test device is connected to a coaxial plug (55).

11. Apparatus according to Claim 10, **characterized in that** plated-through contacts (D13) are provided on the triplate line along the external contour of the coaxial plug (55), between the metallization plane on the module side (E1) and the metallization plane remote from the module (E3) of the triplate line.

12. Apparatus according to one of the preceding claims, **characterized in that** direct-current and control signals can be transmitted via the line substrate (5) and further contact pins, which are provided within the contact-making unit (3), between the T/R module (1) and a printed circuit board which is arranged on the line substrate (5), wherein the signal is carried within the metallization plane on the module side (E1) of the triplate line.

13. Apparatus according to one of the preceding claims, **characterized in that** it comprises a pressure plate (19) which presses onto the housing of the T/R module (1), wherein the pressure plate (19) is embodied in a stepped fashion at at least one of its edges.

## Revendications

1. Ensemble de mise en contact d'un module T/R (1) avec un dispositif de test en vue de la transmission de signaux HF, l'ensemble comportant les éléments suivants :
une unité (3) de mise en contact, en forme de bâti et guidée mécaniquement, qui présente plusieurs éléments de contact (31) qui assurent le contact avec le module T/R (1), l'unité de contact (3) englobant le module T/R (1) pour assurer la mise en contact, l'unité de contact (3) étant de ce fait positionnée par rapport au module T/R (1) de telle sorte que le contact avec le module T/R (1) soit établi par l'intermédiaire des éléments de contact (31) dans une phase de travail,
un substrat conducteur (5) disposé sur l'unité de contact (3), raccordé électriquement à cette dernière et configuré comme conducteur triple blindé par lequel les signaux HF peuvent être transmis à l'unité de test.

2. Ensemble selon la revendication 1, **caractérisé en ce qu'**il présente une cuvette (18) dans laquelle le module T/R (1) à tester est placé pour être positionné grossièrement.

3. Ensemble selon les revendications 1 ou 2, **caractérisé en ce que** les éléments de contact (31) de l'unité de contact (3) sont configurés comme tiges élastiques de contact qui, lors du contact, touchent des surfaces métalliques de contact (80, 81) prévues
sur le substrat conducteur (5) et le module T/R (1).

4. Ensemble selon la revendication 3, **caractérisé en ce que** les éléments de contact (31) de l'unité de contact (3) qui assurent le contact sont entourés par d'autres éléments de contact qui assurent le blindage du signal HF.

5. Ensemble selon l'une des revendications précédentes, **caractérisé en ce que** le signal HF est amené par l'intermédiaire d'un passage de contact (D12) depuis le plan (E1) situé côté module jusqu'au plan central (E2) de métallisation de conducteur triple.

6. Ensemble selon la revendication 5, **caractérisé en ce que** le passage de contact pour le signal HF (D12) est entouré par des passages de contact (D13) situés entre le plan (E1) côté module et le plan (E3) de métallisation éloigné du module du conducteur triple.

7. Ensemble selon l'une des revendications précédentes, **caractérisé en ce que** d'autres passages de contact (D13) entre le plan (E1) côté module et le plan (E3) de métallisation éloigné du module sont prévus des deux côtés le long du conducteur intérieur (60) du plan central (E2) de métallisation.

8. Ensemble selon les revendications 6 ou 7, **caractérisé en ce que** les passages de contact (D13) prévus entre le plan (E1) côté module et le plan (E3) de métallisation éloigné du module sont reliés les uns aux autres dans le plan central (E2) de métallisation au moyen d'une surface de métallisation (130).

9. Ensemble selon l'une des revendications 2 à 8 qui précèdent, **caractérisé en ce qu'**une transition vers un conducteur coplanaire blindé est prévue à l'extrémité du conducteur triple.

10. Ensemble selon la revendication 9, **caractérisé en ce que** le conducteur coplanaire est raccordé à une fiche coaxiale (55) en vue de son raccordement au dispositif de test.

11. Ensemble selon la revendication 10, **caractérisé en ce que** des passages de contact (D13) entre le plan (E1) côté module et le plan (E3) de métallisation éloigné du module du conducteur triple sont prévus sur le conducteur triple le long du contour extérieur de la fiche coaxiale (55).

12. Ensemble selon l'une des revendications précédentes, **caractérisé en ce que** des signaux à courant continu et de commande peuvent être transmis entre une carte de circuit disposée sur le substrat conducteur (5) et le module T/R (1) par l'intermédiaire du substrat conducteur (5) et d'autres tiges de contact prévues à l'intérieur de l'unité de contact (3), le guidage des signaux ayant lieu à l'intérieur du plan (E1) de métallisation côté module du conducteur triple.

13. Ensemble selon l'une des revendications précédentes, **caractérisé en ce qu'**il comporte une plaque de poussée (19) qui repousse le boîtier du module T/R (1), la plaque de poussée (19) étant configurée en gradin sur au moins l'un de ses bords.
